# EUROPEAN PATENT SPECIFICATION

(11) **EP 4 423 935 B1**
(45) Date of publication and mention of the grant of the patent: **02.12.2026**
(21) Application number: 21961804.8
(22) Date of filing: 28.10.2021
(51) Int. Cl.: H04L 1/00, H03F 1/32, H03F 3/24, H03F 3/189, H03F 3/68, H04B 1/04

(54) **DIGITAL PREDISTORTION METHOD AND DIGITAL PREDISTORTION APPARATUS**
DIGITALES VORVERZERRUNGSVERFAHREN UND DIGITALE VORVERZERRUNGSVORRICHTUNG
PROCÉDÉ DE PRÉDISTORSION NUMÉRIQUE ET APPAREIL DE PRÉDISTORSION NUMÉRIQUE

(43) Date of publication of application: 04.09.2024
(73) Proprietor: Telefonaktiebolaget LM Ericsson (publ), 164 83 Stockholm (SE)
(72) Inventor: ZHENG, Yunji, Beijing 100102 (CN); WANG, Lilei, Beijing 100102 (CN); CAO, Haiying, Beijing 100102 (CN); LIU, Yahui, Beijing 100102 (CN)
(74) Representative: Ericsson
(86) International application number: PCT/CN2021/127041
(87) International publication number: WO 2023/070438

(56) References cited:
- WO-A1-2016/154933
- US-A1- 2010 308 910
- US-A1- 2014 105 327
- US-A1- 2014 210 549
- US-A1- 2019 238 204
- US-A1- 2020 169 334
- US-A1- 2020 259 465
- AHMAD IJAZ ET AL: "Machine Learning Meets Communication Networks: Current Trends and Future Challenges", IEEE ACCESS, IEEE, USA, vol. 8, 1 December 2020 (2020-12-01), pages 223418 - 223460, XP011827554, DOI: 10.1109/ACCESS.2020.3041765

## Description

### TECHNICAL FIELD

The non-limiting and exemplary embodiments of the present disclosure generally relate to the technical field of power amplifier (PA), and specifically to a digital predistortion (DPD) method and a DPD apparatus.

### BACKGROUND

This section introduces aspects that may facilitate a better understanding of the disclosure. Accordingly, the statements of this section are to be read in this light and are not to be understood as admissions about what is in the prior art or what is not in the prior art.

Currently, PA is widely used in radio system. DPD methods and apparatuses are designed to control unwanted emissions and nonlinear distortion stemming from nonlinear PAs. However, as various factors/conditions affecting linearization characteristic of PA change dynamically, DPD passively follows and adapts, which always involves a period for DPD to converge. During the time to converge, throughput will deteriorate and PA linearity performance is impacted. If DPD takes a long time to converge or DPD needs to converge frequently, case becomes worse. In addition, existing DPD algorithm optimization approaches may increase computing complexity of DPD algorithm and thus power consumption and implementation complexity of digital front end (DFE). Moreover, there is a need to improve PA efficiency without impacting DPD performance.

AHMAD IJAZ ET AL: "Machine Learning Meets Communication Networks: Current Trends and Future Challenges", IEEE ACCESS, IEEE, USA, vol. 8, 1 December 2020 (2020-12-01), pages 223418-223460, XP011827554, DOI: 10.1109/ACCESS.2020.3041765, discloses the application of ML in communication networks is described in: i) the three layers, i.e., physical, access, and network layers; and ii) novel computing and networking concepts such as Multi-access Edge Computing (MEC), Software Defined Networking (SDN), Network Functions Virtualization (NFV), and a brief overview of ML-based network security.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

To overcome or mitigate at least one of the above mentioned problems or other problems or provide a useful solution, embodiments of the present disclosure propose a DPD method and a DPD apparatus for PA.

In a first aspect of the disclosure, there is provided a DPD method for PA. The method comprises: in accordance with a predicted traffic condition associated with a future time, determining PA related parameters for the future time; and applying the determined PA related parameters when the future time comes. The PA related parameters comprise DPD coefficients and a PA biasing configuration, and the PA biasing configuration comprises at least one of a voltage drain (Vdd) of the PA, a voltage gate (Vgg) of the PA and a load impedance of the PA. The predicted traffic condition is predicted by an Artificial Intelligence (AI) module. The future time comprises a time slot in future. The traffic condition comprises at least one of a mean power level, a maximum power level, a minimum power level, a variance of power level, a physical resource block (PRB) utilization ratio and a confident level. The determining PA related parameters for the future time comprises: looking up in a mapping table with the predicted traffic condition as an index to find an item in the mapping table whose traffic condition value matching the predicted traffic condition. The mapping table comprises a plurality of items and each item comprises a traffic condition and PA related parameters; and determining the PA related parameters in the found item as the PA related parameters for the future time.

In an embodiment, the each item further comprises a radio identity and/or a branch identity.

In an embodiment, the mapping table is created by: applying test signals with a set of predetermined traffic condition to the PA under a set of predetermined PA biasing configuration; for each predetermined traffic condition and each predetermined PA biasing configuration, obtaining converged DPD coefficients; and creating an item in the mapping table with corresponding predetermined traffic condition, predetermined PA biasing configuration and converged DPD coefficients.

In an embodiment, after applying the determined PA related parameters, if DPD performance meets a first predetermined criteria, the method further comprises: updating the mapping table with actual traffic condition and PA related parameters.

In an embodiment, the updating is performed when a PA efficiency meets a second predetermined criteria.

In an embodiment, after applying the determined PA related parameters, if DPD performance doesn't meet a first predetermined criteria, the method further comprises: changing the DPD coefficients until the DPD performance meets the first predetermined criteria; and updating the mapping table with actual traffic condition and PA related parameters.

In an embodiment, after applying the determined PA related parameters, if a PA efficiency doesn't meet a second predetermined criteria, the method further comprises: changing the PA biasing configuration until the PA efficiency meets the second predetermined criteria and the DPD performance meets the first predetermined criteria; and updating the mapping table with actual traffic condition and PA related parameters.

In an embodiment, the AI module is trained with historical traffic condition and is updated with actual traffic condition.

In an embodiment, the applying is performed when the confident level meets a third predetermined criteria.

In an embodiment, the applying is not performed when the confident level doesn't meet the third predetermined criteria; and the method further comprises: if DPD performance doesn't meet a first predetermined criteria, changing the DPD coefficients until the DPD performance meets the first predetermined criteria; and updating the mapping table with actual traffic condition and PA related parameters; AND if the DPD performance meets the first predetermined criteria, updating the mapping table with actual traffic condition and PA related parameters.

In an embodiment, if a PA efficiency doesn't meet a second predetermined criteria, changing the PA biasing configuration until the PA efficiency meets the second predetermined criteria and the DPD performance meets the first predetermined criteria; and updating the mapping table with actual traffic condition and PA related parameters; AND if the PA efficiency meets the second predetermined criteria and the DPD performance meets the first predetermined criteria, updating the mapping table with actual traffic condition and PA related parameters.

In a second aspect of the disclosure, there is provided a DPD apparatus for PA. The apparatus comprises: a communication interface; a processor; and a memory coupled to the processor, said memory containing instructions executable by said processor, whereby the DPD apparatus is operative to perform a method according to the first aspect.

In a third aspect of the disclosure, there is provided a computer-readable storage medium. The computer-readable storage medium stores instructions which when executed by at least one processor, cause the at least one processor to perform the method according to the first aspect.

With the present invention, proper PA related parameters that are suitable for PA can be determined accurately and used. Thus, DPD may stay converged or may only need a short time to converge. Therefore, PA linearity performance and thus throughput are not impacted due to DPD convergence procedure. Calculation load for DPD is also reduced. In addition, PA efficiency are also good due to proper PA related parameters.

### BRIEF DESCRIPTION OF THE DRAWINGS

The above and other aspects, features, and benefits of various embodiments of the present disclosure will become more fully apparent, by way of example, from the following detailed description with reference to the accompanying drawings, in which like reference numerals or letters are used to designate like or equivalent elements. The drawings are illustrated for facilitating better understanding of the embodiments of the disclosure and not necessarily drawn to scale, in which:
FIG.1 shows an example of DPD system architecture;
FIG.2 shows a flowchart of a method 100 according to an embodiment of the present disclosure;
FIG.3 shows a structural example of base station to which method 100 is applied;
FIG.4 shows one example of the traffic prediction unit 201 according to an embodiment of the present disclosure;
FIG.5 shows a classic radio architecture;
FIG.6 shows a new air radio architecture;
FIG.7 shows GaN Trapping result; and
FIG.8 is a block diagram of DPD apparatus for PA according to embodiments of the present disclosure.

### DETAILED DESCRIPTION

The embodiments of the present disclosure are described in detail with reference to the accompanying drawings. It should be understood that these embodiments are discussed only for the purpose of enabling those skilled persons in the art to better understand and thus implement the present disclosure, rather than suggesting any limitations on the scope of the present disclosure. Reference throughout this specification to features, advantages, or similar language does not imply that all of the features and advantages that may be realized with the present disclosure should be or are in any single embodiment of the disclosure. Rather, language referring to the features and advantages is understood to mean that a specific feature, advantage, or characteristic described in connection with an embodiment is included in at least one embodiment of the present disclosure. Furthermore, the described features, advantages, and characteristics of the disclosure may be combined in any suitable manner in one or more embodiments. One skilled in the relevant art will recognize that the disclosure may be practiced without one or more of the specific features or advantages of a particular embodiment. In other instances, additional features and advantages may be recognized in certain embodiments that may not be present in all embodiments of the disclosure.

References in the specification to "one embodiment," "an embodiment," "an example embodiment," and the like indicate that the embodiment described may include a particular feature, structure, or characteristic, but it is not necessary that every embodiment includes the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

It shall be understood that although the terms "first" and "second" etc. may be used herein to describe various elements, these elements should not be limited by these terms. These terms are only used to distinguish one element from another. For example, a first element could be termed a second element, and similarly, a second element could be termed a first element, without departing from the scope of example embodiments. As used herein, the term "and/or" includes any and all combinations of one or more of the associated listed terms.

The terminology used herein is for the purpose of describing particular embodiments only and is not intended to be limiting of example embodiments. As used herein, the singular forms "a", "an" and "the" are intended to include the plural forms as well, unless the context clearly indicates otherwise. It will be further understood that the terms "comprises", "comprising", "has", "having", "includes" and/or "including", when used herein, specify the presence of stated features, elements, and/or components etc., but do not preclude the presence or addition of one or more other features, elements, components and/ or combinations thereof.

It is noted that the terms as used in this document are used only for ease of description and differentiation among nodes, devices or networks etc. With the development of the technology, other terms with the similar/same meanings may also be used.

In the following description and claims, unless defined otherwise, all technical and scientific terms used herein have the same meaning as commonly understood by one of ordinary skills in the art to which this disclosure belongs.

A wireless network generally comprises three parts, i.e., a core network, a radio access network (RAN), and end-user devices like smartphones. The RAN comprises giant cell towers where base stations are located, and it is basically a relay system with a multitude of cell towers in a given region. A base station itself typically comprises two separate systems, a building baseband unit (BBU) and a remote radio unit (RRU). The BBU, which is situated on the ground, handles the RF processing functions. It serves as an interface between the base station and the core network. The RRU, which is on top of the cell tower, handles conversion of RF signals, while the antenna transmits and receives the signals. The PA is located in RRU.

Operators are now deploying 5G, in which there are 32 or 64 transmitting chains. 5G New Radio (NR) mobile networks, build on multicarrier modulation, most notably orthogonal frequency division multiplexing (OFDM). OFDM waveforms are known to contain high peak-to-average power-ratio (PAPR), which complicates utilizing highly nonlinear PAs in transmitters operating close to saturation. There are a number of linearization techniques that have been extensively researched to improve PA efficiency, such as feed-forward, feedback and DPD. DPD is, generally, an approach to control the unwanted emissions and nonlinear distortion stemming from nonlinear PAs. Especially when combined with appropriate PAPR reduction methods, DPD based systems can improve the transmitter power efficiency while keeping the unwanted emissions within specified limits.

Some of the most common approaches in PA direct modeling as well as DPD processing are memory polynomial (MP) and generalized memory polynomial (GMP), both of which can be interpreted to be special cases of the Volterra series. Such approaches allow for efficient direct and inverse modeling of nonlinear systems with memory, while also supporting straight-forward parameter estimation. However, the processing complexity per linearized sample is also relatively high, particularly with GMP and other more complete Volterra series type of approaches, though also some works exist where complexity reduction is pursued. Specifically, the works in pre-distorter and PA modeling methods that build on spline-based basis functions-interpolated lookup tables (LUTs). However, DPD still needs to take a period to converge when PA's characteristic changes. As a result, the throughput will deteriorate during this period.

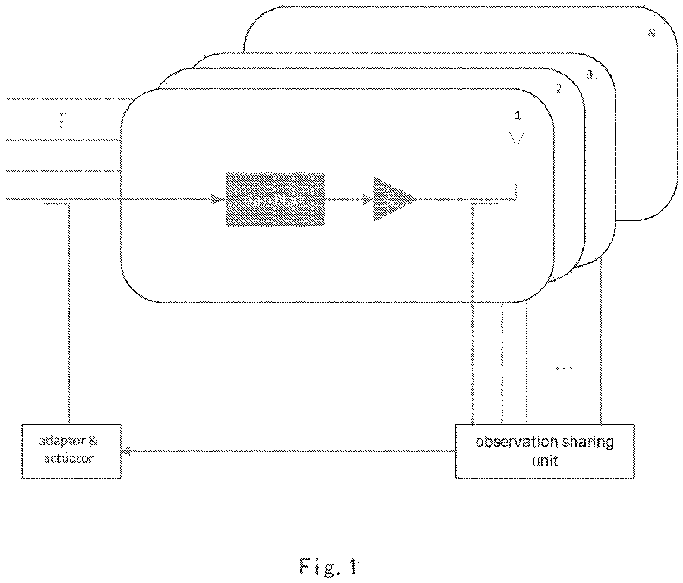

As shown in Fig. 1, DPD is commonly implemented in radio DFE function block. It comprises an observation sharing unit, an adaptor and an actuator, etc. 1~N represent radio branches 1~N, where N is an integer larger than 1. Gain Block is a signal amplifying module including amplifiers. The observation sharing unit couples to PA output and captures an observation signal from the PA output. The adaptor identifies DPD coefficients based on the observation signal. The actuator uses DPD coefficients to generate pre-distorted signals and feeds the pre-distorted signals to PA. In accordance with the observation signal, the DPD algorithm changes DPD coefficients to minimize the difference between the original input signal before DPD and the actual output signal after PA, by which DPD algorithm gradually converges.

As mentioned above, due to various reasons, PA characteristics change dynamically from time to time. Thus, DPD coefficients have to follow and adapt themselves to suit for current PA characteristics. This involves/introduces DPD convergence period, during which throughput is degraded due to non-linearity of PA. PA linearity performance is impacted during the DPD convergence period. In addition, existing DPD improvement algorithm increases computing complexity of DPD algorithm and thus power consumption and implementation complexity of DFE. In addition, PA efficiency needs to be improved without impacting PA linearity performance.

Therefore, there is a need for a new DPD method and DPD apparatus that can effectively decrease DPD convergence period and preferably at low computing complexity cost.

The core idea of the present invention is to predict PA characteristic change (mainly due to traffic condition change) and to adapt PA related parameters (such as PA biasing configuration and/or DPD coefficients) to the PA characteristic change in advance. The properly predicted PA related parameters grantee that DPD coefficients are already converged or nearly converged, that is, already matched with the PA characteristic change. Thus, when the PA characteristic change happens, there is no need for DPD coefficients to take a long time to converge. Therefore, the time for convergence of DPD coefficients is greatly reduced. PA linearization performance is not impacted. The properly predicted PA related parameters also grantee that PA biasing configuration is suitable for PA characteristic and thus PA efficiency can stay high without being impacted due to change of PA characteristic. Since less DPD convergence procedure is needed, the computing complexity of DPD algorithm is lowered and limited.

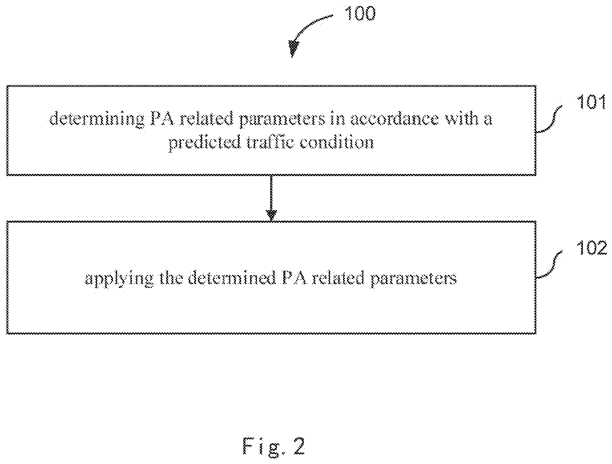

FIG. 2 shows a flowchart of a method 100 according to an embodiment of the present disclosure.

At block 101, in accordance with a predicted traffic condition associated with a future time, PA related parameters for the future time is determined.

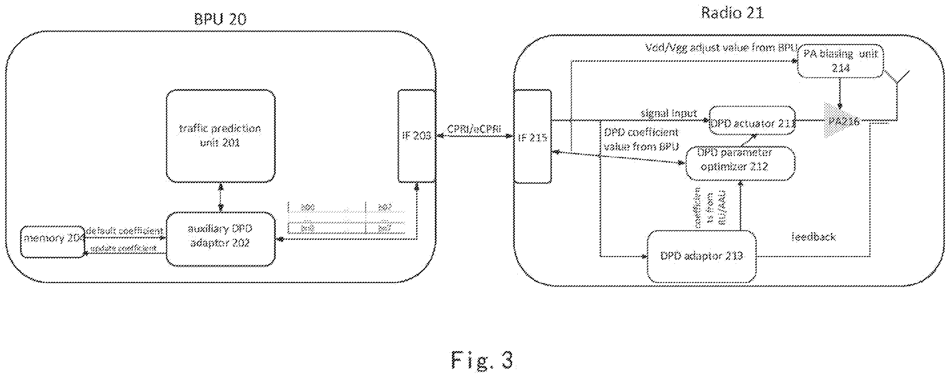

FIG. 3 shows a structural example of base station to which method 100 is applied.

In Fig. 3, BPU 20 comprises a traffic prediction unit 201, an auxiliary DPD adaptor 202, an interface (IF) 203 and memory 204.

The traffic prediction unit 201 predicts a traffic condition associated with a future time. The traffic condition may influence PA physical characteristics which leads to possible need for adaption of PA related parameters such as DPD coefficients. The traffic condition comprises at least one of a mean power level of input signal, a maximum power level of input signal, a minimum power level of input signal, a variance of power level of input signal, a physical resource block (PRB) utilization ratio and a confident level. The variance of power level of input signal reflects differences/offsets between the mean power level and the maximum/minimum power level. The PRB utilization ratio corresponds to the mean/maximum/minimum power level and the variance of power level and there is a mapping relationship between the PRB utilization ratio and the mean/maximum/minimum power level and the variance of power level. The confident level reflects how trustful the predicted traffic condition is.

The traffic prediction unit 201 may be implemented by an Artificial Intelligence (AI) module. The AI module may be based on machine learning, deep learning or other AI technology. The AI module may be trained with historical traffic condition data associated with elapsed time. The trained AI module may output the predicted traffic condition associated with a future time. The future time may indicate a specific time slot. The specific time slot may be represented by a starting timing and an ending timing, or may be represented by a starting timing/time offset and a time length. The time length of the time slot may be e.g., short (1ms), middle (10ms), long (100ms) and very long (1s-10s). However, it is not limited to the above four lengths, and it may be adjusted according to different use cases. It is assumed that PA physical characteristics are relatively stable for the given time slot and thus the PA related parameters from the present invention is suitable for the given time slot. The AI module may be updated with actual traffic condition because BPU is aware of this information.

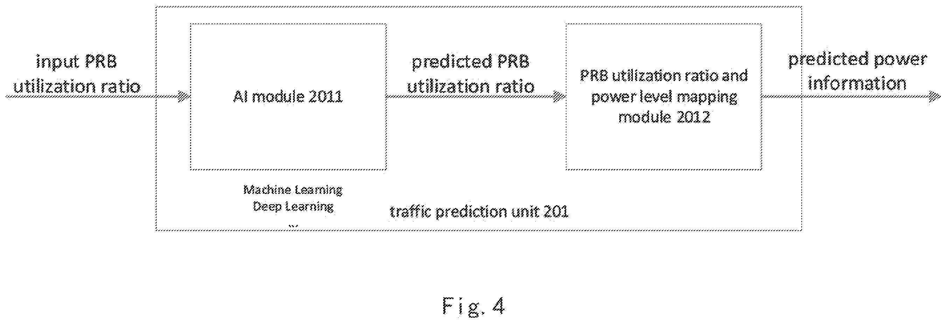

FIG. 4 shows one example of the traffic prediction unit 201 according to an embodiment of the present disclosure.

During training phase and updating phase, AI module 2011 is fed with input PRB utilization ratio data. The trained AI module 2011 may output predicted PRB utilization ratio data and a confident level. A mapping module 2012 may map the predicted PRB utilization ratio to power level data (e.g., a mean power level of input signal, a maximum power level of input signal, a minimum power level of input signal and/or a variance of power level of input signal). The predicted power level data and the confident level may be output by the traffic prediction unit 201 as the predicted traffic condition. Those skilled in the art can understand that other implementation of the traffic prediction unit 201 is possible, for example, the training data for the AI module 2011 may be power level data and the output data of the AI module 2011 is power level data.

The auxiliary DPD adaptor 202 determines PA related parameters for the future time in accordance with a predicted traffic condition associated with a future time.

The PA related parameters comprise DPD coefficients and a PA biasing configuration, and the PA biasing configuration comprises at least one of a voltage drain (V_{dd}) of the PA, a voltage gate (V_{gg}) of the PA and a load impedance of the PA. The load impedance of the PA may be adjusted in various ways. For example, the load impedance of the PA may be adjusted by adjusting capacity value of an adjustable capacitor parallel to the load of the PA.

In one embodiment, the determining PA related parameters for the future time comprises: looking up in a mapping table with the predicted traffic condition as an index to find an item in the mapping table whose traffic condition value matching the predicted traffic condition, wherein the mapping table comprises a plurality of items and each item comprises a traffic condition and PA related parameters; and determining the PA related parameters in the found item as the PA related parameters for the future time.

Specifically, the mapping table comprises a plurality of mapping relationships between traffic conditions and PA related parameters. By using predicted traffic condition as an index, the auxiliary DPD adaptor 202 may match one traffic condition of one item of the mapping table with the predicted traffic condition, in order to identify the PA related parameters in said item as suitable PA related parameters for the predicted traffic condition. The matching of traffic conditions may be made based on measurements on difference between traffic conditions. If the difference is below certain threshold, matching may be confirmed. In one embodiment, each item may further comprises a radio identity and/or a branch identity so that the item is further related to a radio and/or a radio branch. During the looking up process for matched traffic condition, searching is only performed among the items with the same radio/branch identity as PA. Memory 204 stores the mapping table.

In one embodiment, the mapping table is created by: applying test signals with a set of predetermined traffic conditions to the PA under a set of predetermined PA biasing configurations; for each predetermined traffic condition and each predetermined PA biasing configuration, obtaining converged DPD coefficients; and creating an item in the mapping table with corresponding predetermined traffic condition, predetermined PA biasing configuration and converged DPD coefficients.

See Fig. 3, when radio 21 initializes, it enters into a calibration phase. During the calibration phase, several predetermined various traffic conditions and several predetermined PA biasing configurations are applied to radio 21. Traditional DPD algorithm mentioned above is started until DPD coefficients converge. The corresponding predetermined traffic condition, predetermined PA biasing configuration and converged DPD coefficients as well as radio/branch identity may be obtained and stored in radio 21 and transferred to the auxiliary DPD adaptor 202 via IF 215 and IF 203 (radio 21 and BPU 20 are connected through fronthaul). Specifically, the test signals with predetermined various traffic conditions are fed to a DPD actuator 211, and the DPD actuator 211 performs DPD with default DPD coefficients for the first loop. The predetermined PA biasing configurations are fed to a PA biasing unit 214, which in turn changes the biasing of PA 216. DPD adaptor 213, as traditional DPD adaptor, observes the difference between output of PA 216 and original input signal, changes DPD coefficients based on the difference, and supplies new DPD coefficients to DPD parameter optimizer 212. In calibration phase, the DPD parameter optimizer 212 is transparent and does not receive input from the auxiliary DPD adaptor 202. The new DPD coefficients are fed to the PD actuator 211 for execution. Loops continue until DPD coefficients are converged. Then, information for creating items of the mapping table is obtained. Thus, the mapping table may be generated.

Table 1 shows an embodiment of data format. The data format may be used for mapping table, mapping table generation process, feedback process during radio working phase to be explained below, etc.

**Table 1 data format information**

| Information-1 | Information-2 | Information-3 | Inform ation-4 | Informati on-5 | Informati on-6 |
|---|---|---|---|---|---|
| radio branch information | PA biasing information | traffic load information | DPD coeffic ient | DPD performa nce feedback | time length and offset |
| unsign (b7, b6... b0), in which b0-b5 means branch number or branch group number; b6-b7 means radio identify information , e.g., 00 for radio1, 01 for radio2, ... | sign (b15,b14... b 0), in which b15 is sign bit, b14, b13, b12 are V_{gg}, V_{dd} Delta information and, b11-b8 are for load impedance adjustment of the PA, and other bits are reserved | unsign (b16,b15,b14... b0), in which the first 6 bits means average power, 2^{nd} 5 bits means variance and last 5 bits means confident level | sign (b7, b6... b0 ), in which b7 is sign bit and other bits are coeffic ient values | unsign (b7-b0), in which b7-b0 indicate DPD performa nce (e.g., converge or error) | unsign (b7-b0), in which b3-b0 indicate predict timing length, b7-b4 indicate the offset from BPU to radio) |

At block 102 of Fig. 1, the determined PA related parameters are applied when the future time comes.

During radio working phase, the determined PA biasing configuration and the determined DPD coefficients are supplied to the DPD parameter optimizer 212. At the beginning of the time slot corresponding to the determined PA biasing configuration and DPD coefficients, the DPD parameter optimizer 212 selects the determined DPD coefficients and supplies them to the DPD actuator 211. The DPD parameter optimizer 212 also supplies the determined PA biasing configuration to the PA biasing unit 214. The PA biasing unit 214 applies the determined PA biasing configuration to the PA 216. The DPD actuator 211 applies the determined DPD coefficients to the input signal.

For example, assume y[n] is the output from the DPD actuator 211, coeff is the determined DPD coefficients, and x[n] is the input signal to the DPD actuator 211 before subjected to DPD.$y \left[n\right] = coeff * x \left[n\right]$

Then, the difference (or called error) e(n) between the actual output signal r[n] observed from PA output and the original input signal x[n] is evaluated. The DPD parameter optimizer 212 may observe and monitor the difference.$e \left[n\right] = r \left[n\right] - x \left[n\right]$

In an embodiment, if DPD performance meets a first predetermined criteria, for example, error e(n) is below a certain threshold, it means that the determined DPD coefficients are already converged under the determined PA biasing configuration. Thus, there is no need to endure the convergence procedure during which throughput is degraded and PA linearity performance is impacted. Compared with traditional DPD algorithm which needs a convergence period to get proper DPD coefficients, overall time for convergence is greatly reduced. Calculation load for DPD is reduced.

In an embodiment, if DPD performance meets the first predetermined criteria and the PA efficiency meets a second predetermined criteria, for example, PA efficiency is above a certain threshold, it means not only the determined DPD coefficients are converged but also the PA efficiency is high. Compared with traditional DPD algorithm, not only time for convergence is reduced, but also the PA efficiency is high. Energy can be saved and efficiency can be improved as well.

In an embodiment, if DPD performance meets the first predetermined criteria, DPD parameter optimizer 212 may feedback to the auxiliary DPD adaptor 202 that DPD performance is good. In another embodiment, if both DPD performance meets the first predetermined criteria and the PA efficiency meets the second predetermined criteria, the DPD parameter optimizer 212 may feedback to the auxiliary DPD adaptor 202 that DPD performance is good.

If the feedback that DPD performance is good, the auxiliary DPD adaptor 202 may update the mapping table by inserting a new item which comprises the actual traffic condition (which is aware and supplied by BPU 20), the determined PA biasing configuration and the determined DPD coefficients, when the actual traffic condition is not already in the mapping table. Information 1-6 of table 1 may all be updated when available.

In an embodiment, if DPD performance doesn't meet the first predetermined criteria, which means that the determined DPD coefficients is not yet converged under the determined PA biasing configuration. In this case, traditional DPD convergence procedure starts. The DPD adaptor 213 is enabled. The DPD parameter optimizer 212 selects updated DPD coefficients from the DPD adaptor 213 and feeds to the DPD actuator 211. After several loops of updating DPD coefficients, the DPD coefficients gradually converge. Compared with traditional DPD algorithm which needs a relatively long convergence period to get proper DPD coefficients, since the determined PA related parameters are based on predicted traffic condition, the determined DPD coefficients are closer to the final converged DPD coefficients than default value or lately used value that is utilized by traditional DPD algorithm. Thus, the convergence procedure during which throughput is degraded and PA linearity performance is impacted is shortened. The overall time for convergence is relatively reduced. Calculation load for DPD is reduced.

In an embodiment, if PA efficiency doesn't meet a second predetermined criteria, to improve PA efficiency, the PA biasing unit 214 may change the PA biasing configuration. Traditional DPD convergence procedure starts under the changed PA biasing configuration. In the end, both the PA efficiency meets the second predetermined criteria and the DPD performance meets the first predetermined criteria. Similarly, since the determined PA related parameters are based on predicted traffic condition, the determined PA biasing configuration and the determined DPD coefficients are closer to the final PA biasing configuration and the final converged DPD coefficients than those utilized by traditional DPD algorithm. Thus, the convergence procedure during which throughput is degraded and PA linearity performance is impacted is shortened. The overall time for convergence is relatively reduced. Calculation load for DPD is reduced. PA efficiency can be improved without introducing more DPD convergence procedures. PA efficiency benefits due to adaption of PA biasing configuration to PA characteristic change.

In an embodiment, if DPD performance does not meet the first predetermined criteria and/or the PA efficiency does not meet the second predetermined criteria, the DPD parameter optimizer 212 may feedback to the auxiliary DPD adaptor 202 that DPD performance is bad. That means that the predicted traffic condition is not accurate enough. The traffic prediction unit 201 may be feedback with the actual traffic condition (which is aware and supplied by BPU 20) and the traffic prediction accuracy may be improved with feedback.

After obtaining the final DPD coefficients that meet the first predetermined criteria (in another embodiment, also after obtaining the final PA biasing configuration that meet the second predetermined criteria), the PA biasing unit 214 and the DPD parameter optimizer 212 may feedback the final PA biasing configuration and the final DPD coefficients to the auxiliary DPD adaptor 202. The auxiliary DPD adaptor 202 may update the mapping table by inserting a new item which comprises the actual traffic condition, the final PA biasing configuration and the final DPD coefficients. Information 1-6 of table 1 may all be updated when available. Next time when the same traffic condition appears, the final PA biasing configuration and the final DPD coefficients which are suitable will be directly used without a new DPD convergence procedure. Therefore, the convergence procedure during which throughput is degraded and PA linearity performance is impacted is shortened. The overall time for convergence is relatively reduced. Calculation load for DPD is reduced. PA efficiency can be improved without introducing more DPD convergence procedures. PA efficiency benefits due to adaption of PA biasing configuration to PA characteristic change.

In an embodiment, block 102 of Fig. 1 is performed on a condition that the confident level meets a third predetermined criteria. For example, the third predetermined criteria may be the confident level for the predicted traffic condition is above a preset threshold. When the confident level meets the third predetermined criteria, block 102 is performed as above.

In an embodiment, when the confident level does not meet the third predetermined criteria, if the DPD performance meets the first predetermined criteria, the mapping table may be updated with actual traffic condition and PA related parameters. The actual traffic condition may be feedback to the traffic prediction unit 201 for update. When the confident level does not meet the third predetermined criteria, if DPD performance doesn't meet a first predetermined criteria, the DPD coefficients is changed (as in traditional DPD algorithm) until the DPD performance meets the first predetermined criteria; and the mapping table is updated with actual traffic condition and PA related parameters. The actual traffic condition may be feedback to the traffic prediction unit 201 for update.

In an embodiment, when the confident level does not meet the third predetermined criteria, if the PA efficiency meets the second predetermined criteria and the DPD performance meets the first predetermined criteria, the mapping table is updated with actual traffic condition and PA related parameters. The actual traffic condition may be feedback to the traffic prediction unit 201 for update. When the confident level does not meet the third predetermined criteria, if the PA efficiency doesn't meet the second predetermined criteria, the PA biasing configuration is changed until the PA efficiency meets the second predetermined criteria and the DPD performance meets the first predetermined criteria; and the mapping table is updated with actual traffic condition and PA related parameters. The actual traffic condition may be feedback to the traffic prediction unit 201 for update.

With the present invention, predicted traffic condition is used for the determination of PA related parameters. Thus, proper PA related parameters can be determined in advance. When the traffic condition changes, proper PA related parameters are already there for use, rather than being obtained through DPD convergence procedure. It is more beneficial when the traffic condition changes frequently. Even when determined PA related parameters need to further converge a little, the time for convergence is shortened because the starting point of convergence procedure is closer to the end point. In such case, since the actual traffic condition and related actual PA related parameters are updated into the mapping table, the use of mapping table for next time can benefit because more accurate and more proper PA related parameters can be used. With feedback and update, the traffic prediction also become more and more accurate.

The predicted traffic condition, rather than real-time traffic condition or buffered (nearly real-time) traffic condition, is used. The hardware/software cost for buffering and real-time calculating capability can be greatly reduced.

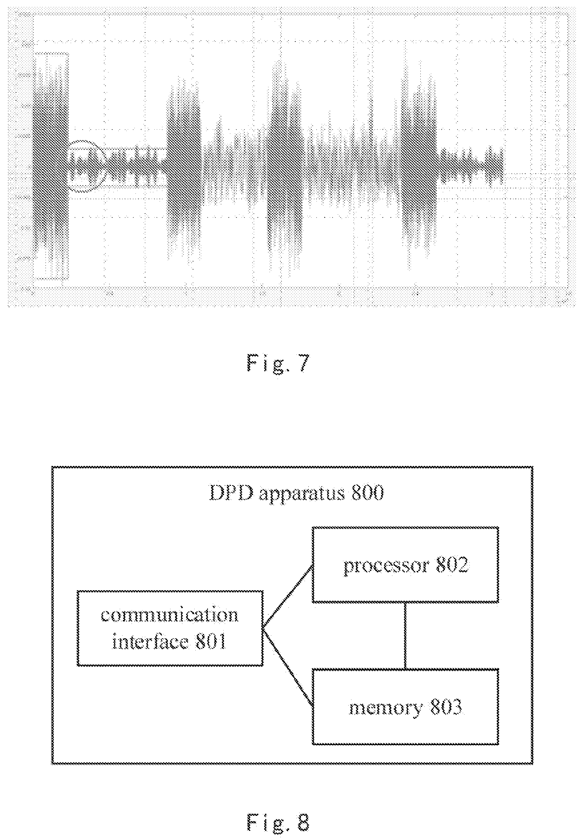

With the present invention, the trapping effect of GaN PA can also be improved. The trapping effect of GaN PA is that the gain and phase of a small signal will change after a large signal, which causes PA characteristic changes and thus the PA model couldn't describe the current PA state, so the PA linearization performance is degraded and the error vector magnitude (EVM) increases. With the present invention, when the traffic prediction unit predicts high dynamic signal, the auxiliary DPD adaptor sends PA related parameters corresponding to the closest power level of the input signal to the DPD parameter optimizer. After a large signal impact, the behavior model of the PA changes, the DPD coefficients are directly reconfigured in the trapping recovery phase such that the trapping effect is improved, see Fig. 7 for GaN trapping compensation result. As shown in Fig. 7, for a 16db peak to average ratio (PAR) dynamic signal, the trapping effect of GaN PA improves due to fast adaption of PA related parameters to PA characteristic change.

### Alternatives:

In Fig. 3, the traffic prediction unit 201 and the auxiliary DPD adaptor 202 are two separate units. Alternatively, the traffic prediction unit 201 and the auxiliary DPD adaptor 202 may be housed in a single unit.

In Fig. 3, the auxiliary DPD adaptor 202 is in BPU 20. Since most modifications are made within BPU 20, the computing complexity of radio 21 does not increase much. Alternatively, the auxiliary DPD adaptor 202 may be housed in radio 21. In another embodiment, the auxiliary DPD adaptor 202 may be merged into the DPD parameter optimizer 212. Since traffic prediction unit 201 is in BPU 20, the computing complexity of radio 21 does not increase much.

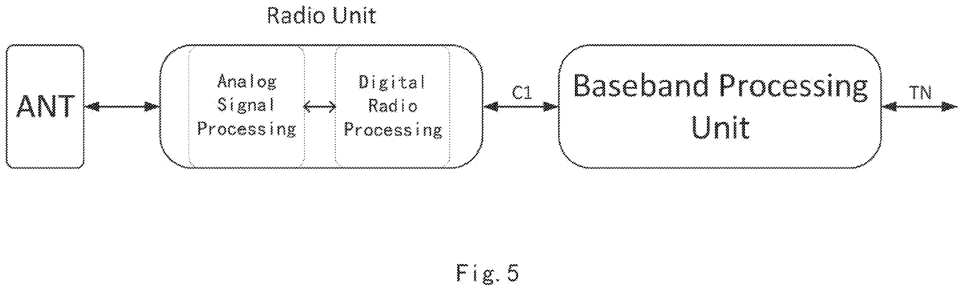

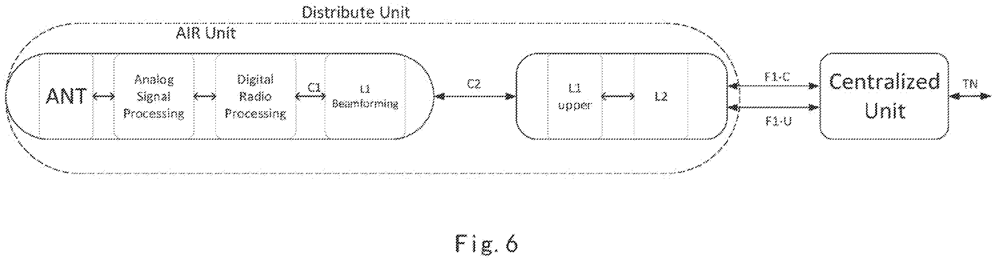

The above description is made with respect to classic radio architecture as shown in Fig. 5. According to 3rd Generation Partnership Project (3GPP), RAN architecture evolves from classic radio architecture including an antenna, a radio (remote) unit and a baseband unit to a new air radio architecture including a distributed unit (DU) and a centralized unit (CU) as shown in Fig. 6. Under the architecture of Fig. 6, the traffic prediction unit 201 resides in CU. The auxiliary DPD adaptor 202 may reside in CU or DU. The DPD parameter optimizer 212 resides in DU.

FIG. 8 is a block diagram of a DPD apparatus for PA according to embodiments of the present disclosure.

The DPD apparatus 800 includes a communication interface 801, a processor 802 and a memory 803. The memory 803 contains instructions executable by the processor 802 whereby the DPD apparatus 800 is operative to perform the actions, e.g., of the procedure described earlier in conjunction with Fig. 2.

In some embodiments, the memory 803 may further contain instructions executable by the processor 802 whereby the DPD apparatus 800 is operative to perform any of the aforementioned methods, steps, and processes.

The present disclosure also provides at least one computer program product in the form of a non-volatile or volatile memory, e.g., a non-transitory computer readable storage medium, an Electrically Erasable Programmable Read-Only Memory (EEPROM), a flash memory and a hard drive. The computer program product includes a computer program. The computer program includes: code/computer readable instructions, which when executed by the processor 802 causes the DPD apparatus 800 to perform the actions, e.g., of the procedure described earlier in conjunction with Fig. 2.

The computer program product may be configured as a computer program code structured in computer program modules. The computer program modules could essentially perform the actions of the flow illustrated in Fig. 2.

The processor may be a single CPU (Central processing unit), but could also comprise two or more processing units. For example, the processor may include general purpose microprocessors; instruction set processors and/or related chips sets and/or special purpose microprocessors such as Application Specific Integrated Circuit (ASICs). The processor may also comprise board memory for caching purposes. The computer program may be carried by a computer program product connected to the processor. The computer program product may comprise a non-transitory computer readable storage medium on which the computer program is stored. For example, the computer program product may be a flash memory, a Random-access memory (RAM), a Read-Only Memory (ROM), or an EEPROM, and the computer program modules described above could in alternative embodiments be distributed on different computer program products in the form of memories.

The techniques described herein may be implemented by various means so that an apparatus implementing one or more functions of a corresponding apparatus described with an embodiment comprises not only prior art means, but also means for implementing the one or more functions of the corresponding apparatus described with the embodiment and it may comprise separate means for each separate function or means that may be configured to perform two or more functions. For example, these techniques may be implemented in hardware (one or more apparatuses), firmware (one or more apparatuses), software (one or more modules), or combinations thereof. For a firmware or software, implementation may be made through modules (e.g., procedures, functions, and so on) that perform the functions described herein.

Exemplary embodiments herein have been described above with reference to block diagrams and flowchart illustrations of methods and apparatuses. It will be understood that each block of the block diagrams and flowchart illustrations, and combinations of blocks in the block diagrams and flowchart illustrations, respectively, can be implemented by various means including computer program instructions. These computer program instructions may be loaded onto a general purpose computer, special purpose computer, or other programmable data processing apparatus to produce a machine, such that the instructions which execute on the computer or other programmable data processing apparatus create means for implementing the functions specified in the flowchart block or blocks.

Further, while operations are depicted in a particular order, this should not be understood as requiring that such operations be performed in the particular order shown or in sequential order, or that all illustrated operations be performed, to achieve desirable results. In certain circumstances, multitasking and parallel processing may be advantageous. Likewise, while several specific implementation details are contained in the above discussions, these should not be construed as limitations on the scope of the subject matter described herein, but rather as descriptions of features that may be specific to particular embodiments. Certain features that are described in the context of separate embodiments may also be implemented in combination in a single embodiment.

While this specification contains many specific implementation details, these should not be construed as limitations on the scope of any implementation or of what may be claimed, but rather as descriptions of features that may be specific to particular embodiments of particular implementations. Certain features that are described in this specification in the context of separate embodiments can also be implemented in combination in a single embodiment.

It will be obvious to a person skilled in the art that, as the technology advances, the inventive concept can be implemented in various ways. The above described embodiments are given for describing rather than limiting the disclosure, and it is to be understood that modifications and variations may be resorted to without departing from the scope of the disclosure as those skilled in the art readily understand. Such modifications and variations are considered to be within the scope of the disclosure and the appended claims. The protection scope of the disclosure is defined by the accompanying claims.

## Claims

1. A digital predistortion (DPD) method (100) for power amplifier (PA), comprising:
in accordance with a predicted traffic condition associated with a future time, determining (101) PA related parameters for the future time; and
applying (102) the determined PA related parameters when the future time comes;
wherein the PA related parameters comprise DPD coefficients and a PA biasing configuration, and the PA biasing configuration comprises at least one of a voltage drain (V_{dd}) of the PA, a voltage gate (V_{gg}) of the PA and a load impedance of the PA;
wherein the predicted traffic condition is predicted by an Artificial Intelligence (AI) module;
wherein the future time comprises a time slot in future;
wherein the traffic condition comprises at least one of a mean power level, a maximum power level, a minimum power level, a variance of power level, a physical resource block (PRB) utilization ratio and a confidence level;
wherein the determining PA related parameters for the future time comprises:
looking up in a mapping table with the predicted traffic condition as an index to find an item in the mapping table whose traffic condition value matches the predicted traffic condition,
wherein the mapping table comprises a plurality of items and each item comprises a traffic condition and PA related parameters; and
determining the PA related parameters in the found item as the PA related parameters for the future time.

2. The method of claim 1, wherein each item further comprises a radio identity and/or a branch identity.

3. The method of claim 1 or 2, wherein the mapping table is created by:
applying test signals with a set of predetermined traffic conditions to the PA under a set of predetermined PA biasing configurations;
for each predetermined traffic condition and each predetermined PA biasing configuration, obtaining converged DPD coefficients; and
creating an item in the mapping table with corresponding predetermined traffic condition, predetermined PA biasing configuration and converged DPD coefficients.

4. The method of any of claims 1-3, wherein after applying the determined PA related parameters, if DPD performance meets a first predetermined criteria, the method further comprises:
updating the mapping table with actual traffic condition and PA related parameters.

5. The method of claim 4, wherein the updating is performed when a PA efficiency meets a second predetermined criteria.

6. The method of any of claims 1-5, wherein after applying the determined PA related parameters, if DPD performance doesn't meet a first predetermined criteria, the method further comprises:
changing the DPD coefficients until the DPD performance meets the first predetermined criteria; and
updating the mapping table with actual traffic condition and PA related parameters.

7. The method of claim 6, wherein after applying the determined PA related parameters, if a PA efficiency doesn't meet a second predetermined criteria, the method further comprises:
changing the PA biasing configuration until the PA efficiency meets the second predetermined criteria and the DPD performance meets the first predetermined criteria; and
updating the mapping table with actual traffic condition and PA related parameters.

8. The method of claim 1, wherein the AI module is trained with historical traffic condition and is updated with actual traffic condition.

9. The method of claim 1, wherein the applying is performed when the confident level meets a third predetermined criteria.

10. A digital predistortion (DPD) apparatus (800) for power amplifier (PA), comprising:
a communication interface (801);
a processor (802); and
a memory (803) coupled to the processor (802), said memory (803) containing instructions executable by said processor (802), whereby the DPD apparatus (800) is operative to perform a method according to any one of claims 1-9.

## Patentansprüche

1. Verfahren (100) zur digitalen Vorverzerrung (DPD) für einen Leistungsverstärker (PA), umfassend:
gemäß einer vorhergesagten Verkehrsbedingung, die mit einem zukünftigen Zeitpunkt assoziiert ist, Bestimmen (101) PA-bezogener Parameter für den zukünftigen Zeitpunkt; und
Anwenden (102) der bestimmten PA-bezogenen Parameter, wenn der zukünftige Zeitpunkt eintritt;
wobei die PA-bezogenen Parameter DPD-Koeffizienten und eine PA-Vorspannungskonfiguration umfassen und die PA-Vorspanungskonfiguration mindestens eines von einer Drain-Spannung (V_{dd}) des PA, einer Gate-Spannung (V_{gg}) des PA und einer Lastimpedanz des PA umfasst;
wobei die vorhergesagte Verkehrsbedingung von einem Modul für künstliche Intelligenz (KI) vorhergesagt wird;
wobei der zukünftige Zeitpunkt einen Zeitschlitz in der Zukunft umfasst;
wobei die Verkehrsbedingung mindestens eines von einem mittleren Leistungspegel, einem maximalen Leistungspegel, einem minimalen Leistungspegel, einer Varianz des Leistungspegels, einem Nutzungsverhältnis physikalischer Ressourcenblöcke (PRB) und einem Konfidenzniveau umfasst;
wobei das Bestimmen PA-bezogener Parameter für den zukünftigen Zeitpunkt Folgendes umfasst:
Nachschlagen in einer Zuordnungstabelle mit der vorhergesagten Verkehrsbedingung als Index, um ein Element in der Zuordnungstabelle zu finden, dessen Verkehrsbedingungswert der vorhergesagten Verkehrsbedingung entspricht,
wobei die Zuordnungstabelle eine Mehrzahl von Elementen umfasst und jedes Element eine Verkehrsbedingung und PA-bezogene Parameter umfasst; und
Bestimmen der PA-bezogenen Parameter in dem gefundenen Element als die PA-bezogenen Parameter für den zukünftigen Zeitpunkt.

2. Verfahren nach Anspruch 1, wobei jedes Element ferner eine Funkidentität und/oder eine Zweigidentität umfasst.

3. Verfahren nach Anspruch 1 oder 2, wobei die Zuordnungstabelle erstellt wird durch:
Anwenden von Testsignalen bei einem Satz von vorbestimmten Verkehrsbedingungen auf den PA gemäß einem Satz von vorbestimmten PA-Vorspannungskonfigurationen;
für jede vorbestimmte Verkehrsbedingung und jede vorbestimmte PA-Vorspannungskonfiguration Erhalten von konvergierten DPD-Koeffizienten; und
Erstellen eines Elements in der Zuordnungstabelle mit der entsprechenden vorbestimmten Verkehrsbedingung, der vorbestimmten PA-Vorspannungskonfiguration und den konvergierten DPD-Koeffizienten.

4. Verfahren nach einem der Ansprüche 1-3, wobei das Verfahren nach dem Anwenden der bestimmten PA-bezogenen Parameter, falls die DPD-Leistung ein erstes vorbestimmtes Kriterium erfüllt, ferner Folgendes umfasst:
Aktualisieren der Zuordnungstabelle mit tatsächlichen Verkehrsbedingungen und PA-bezogenen Parametern.

5. Verfahren nach Anspruch 4, wobei das Aktualisieren durchgeführt wird, wenn eine PA-Effizienz ein zweites vorbestimmtes Kriterium erfüllt.

6. Verfahren nach einem der Ansprüche 1-5, wobei das Verfahren nach dem Anwenden der bestimmten PA-bezogenen Parameter, falls die DPD-Leistung ein erstes vorbestimmtes Kriterium nicht erfüllt, ferner Folgendes umfasst:
Ändern der DPD-Koeffizienten, bis die PDP-Leistung das erste vorbestimmte Kriterium erfüllt; und
Aktualisieren der Zuordnungstabelle mit tatsächlichen Verkehrsbedingungen und PA-bezogenen Parametern.

7. Verfahren nach Anspruch 6, wobei das Verfahren nach dem Anwenden der bestimmten PA-bezogenen Parameter, falls die PA-Leistung ein zweites vorbestimmtes Kriterium nicht erfüllt, ferner Folgendes umfasst:
Ändern der PA-Vorspannungskonfiguration, bis die PA-Effizienz das zweite vorbestimmte Kriterium erfüllt und die DPD-Leistung das erste vorbestimmte Kriterium erfüllt; und
Aktualisieren der Zuordnungstabelle mit tatsächlichen Verkehrsbedingungen und PA-bezogenen Parametern.

8. Verfahren nach Anspruch 1, wobei das KI-Modul mit historischen Verkehrsbedingungen trainiert und mit tatsächlichen Verkehrsbedingungen aktualisiert wird.

9. Verfahren nach Anspruch 1, wobei das Anwenden durchgeführt wird, wenn das Konfidenzniveau ein drittes vorbestimmtes Kriterium erfüllt.

10. Vorrichtung (800) zur digitalen Vorverzerrung (DPD) für einen Leistungsverstärker (PA), umfassend:
eine Kommunikationsschnittstelle (801);
einen Prozessor (802); und
einen Speicher (803), der mit dem Prozessor (802) gekoppelt ist, wobei der Speicher (803) Anweisungen enthält, die vom Prozessor (802) ausgeführt werden können, wodurch die DPD-Vorrichtung (800) zum Durchführen des Verfahrens nach einem der Ansprüche 1-9 ausgelegt ist.

## Revendications

1. Procédé de prédistorsion numérique (DPD) (100) pour un amplificateur de puissance (PA), comprenant :
en fonction d'une condition de trafic prédite associée à un temps futur, la détermination (101) de paramètres liés au PA pour le temps futur ; et
l'application (102) des paramètres liés au PA déterminés au temps futur ;
dans lequel les paramètres liés au PA comprennent des coefficients de DPD et une configuration de polarisation de PA, et la configuration de polarisation de PA comprend au moins l'un parmi un drain de tension (V_{dd}) du PA, une grille de tension (V_{gg}) du PA et une impédance de charge du PA ;
dans lequel la condition de trafic prédite est prédite par un module d'intelligence artificielle (IA) ;
dans lequel le temps futur comprend un créneau temporel à l'avenir ;
dans lequel la condition de trafic comprend au moins l'un parmi un niveau de puissance moyen, un niveau de puissance maximal, un niveau de puissance minimal, une variance de niveau de puissance, un taux d'utilisation de bloc de ressources physiques (PRB) et un niveau de confiance ;
dans lequel la détermination de paramètres liés au PA pour le temps futur comprend :
la recherche dans une table de mappage avec la condition de trafic prédite comme indice pour trouver un élément dans la table de mappage dont une valeur de condition de trafic correspond à la condition de trafic prédite,
dans lequel la table de mappage comprend une pluralité d'éléments et chaque élément comprend une condition de trafic et des paramètres liés au PA ; et
la détermination des paramètres liés au PA dans l'élément trouvé en tant que paramètres liés au PA pour le temps futur.

2. Procédé selon la revendication 1, dans lequel chaque élément comprend en outre une identité radio et/ou une identité de branche.

3. Procédé selon la revendication 1 ou 2, dans lequel la table de mappage est créée par :
l'application de signaux de test avec un ensemble de conditions de trafic prédéterminées au PA dans le cadre d'un ensemble de configurations de polarisation de PA prédéterminées ;
pour chaque condition de trafic prédéterminée et chaque configuration de polarisation de PA prédéterminée, l'obtention de coefficients de DPD convergents ; et
la création d'un élément dans la table de mappage avec une condition de trafic prédéterminée, une configuration de polarisation de PA prédéterminée et des coefficients de DPD convergents correspondants.

4. Procédé selon l'une quelconque des revendications 1 à 3, dans lequel, après l'application des paramètres liés au PA déterminés, si une performance de DPD remplit un premier critère prédéterminé, le procédé comprend en outre :
la mise à jour de la table de mappage avec une condition de trafic réelle et des paramètres liés au PA réels.

5. Procédé selon la revendication 4, dans lequel la mise à jour est réalisée lorsqu'une efficacité de PA remplit un deuxième critère prédéterminé.

6. Procédé selon l'une quelconque des revendications 1 à 5, dans lequel, après l'application des paramètres liés au PA déterminés, si une performance de DPD ne remplit pas un premier critère prédéterminé, le procédé comprend en outre :
la modification des coefficients de DPD jusqu'à ce que la performance de DPD remplisse le premier critère prédéterminé ; et
la mise à jour de la table de mappage avec une condition de trafic réelle et des paramètres liés au PA réels.

7. Procédé selon la revendication 6, dans lequel, après l'application des paramètres liés au PA déterminés, si une efficacité de PA ne remplit pas un deuxième critère prédéterminé, le procédé comprend en outre :
la modification de la configuration de polarisation de PA jusqu'à ce que l'efficacité de PA remplisse le deuxième critère prédéterminé et la performance de DPD remplisse le premier critère prédéterminé ; et
la mise à jour de la table de mappage avec une condition de trafic réelle et des paramètres liés au PA réels.

8. Procédé selon la revendication 1, dans lequel le module d'IA est entraîné avec une condition de trafic historique et est mis à jour avec une condition de trafic réelle.

9. Procédé selon la revendication 1, dans lequel l'application est réalisée lorsque le niveau de confiance remplit un troisième critère prédéterminé.

10. Appareil de prédistorsion numérique (DPD) (800) pour un amplificateur de puissance (PA), comprenant :
une interface de communication (801) ;
un processeur (802) ; et
une mémoire (803) couplée au processeur (802), ladite mémoire (803) contenant des instructions exécutables par ledit processeur (802), selon lesquelles l'appareil DPD (800) est fonctionnel pour réaliser un procédé selon l'une quelconque des revendications 1 à 9.
